# EUROPÄISCHE PATENTSCHRIFT

(11) **EP 4 133 914 B1**
(45) Veröffentlichungstag und Bekanntmachung des Hinweises auf die Patenterteilung: **06.05.2026**
(21) Anmeldenummer: 21716346.8
(22) Anmeldetag: 30.03.2021
(51) Int. Cl.: H05K 5/06

(54) **GEHÄUSEDECKEL UND VERFAHREN ZUM HERSTELLEN EINES GEHÄUSEDECKELS**
HOUSING COVER AND METHOD FOR MANUFACTURING A HOUSING COVER
COUVERCLE DE BOÎTIER ET PROCÉDÉ DE FABRICATION D'UN COUVERCLE DE BOÎTIER

(30) Priorität: 08.04.2020 DE 102020109899
(43) Veröffentlichungstag der Anmeldung: 15.02.2023
(73) Patentinhaber: ElringKlinger AG, 72581 Dettingen (DE)
(72) Erfinder: BETZ, Björn, 72818 Trochtelfingen (DE); SCHÖLLHAMMER, Jochen, 72581 Dettingen (DE); LUTZ, Thilo, 70180 Stuttgart (DE); KUNERT, Tobias, 72764 Reutlingen (DE)
(74) Vertreter: Hoeger, Stellrecht & Partner Patentanwälte mbB
(86) Internationale Anmeldenummer: PCT/EP2021/058341
(87) Internationale Veröffentlichungsnummer: WO 2021/204604

(56) Entgegenhaltungen:
- WO-A1-2020/074482
- DE-B4- 19 880 835
- JP-A- 2015 141 991

## Beschreibung

Die vorliegende Erfindung betrifft einen Gehäusedeckel zum Festlegen an einem Gehäuse, wobei der Gehäusedeckel mit mehreren Befestigungsmittel-Durchtrittsöffnungen und mit einem Dichtungswulst, der ein elastomeres Material umfasst, versehen ist und wobei der Dichtungswulst an einer Dichtungstragefläche des Gehäusedeckels angeordnet ist.

Aus der EP 1 683 997 A2 ist ein Gehäusedeckel bekannt, bei welchem ein Dichtungswulst aus einem Elastomermaterial in einer in den Gehäusedeckel eingeprägten Nut angeordnet ist.

Durch das Erfordernis, in dem Gehäusedeckel eine Nut vorzusehen, deren Breite im unverpressten Zustand des Gehäusedeckels größer sein muss als die Breite des Dichtungswulstes, wird die Gestaltungsfreiheit beim Design des Gehäusedeckels eingeschränkt.

Die DE 198 80 835 B4 und die JP 2015 141991 A offenbaren Gehäusedeckel zum Festlegen an einem Gehäuse gemäß dem Oberbegriff von Anspruch 1.

Der vorliegenden Erfindung liegt die Aufgabe zugrunde, einen Gehäusedeckel der eingangs genannten Art zu schaffen, bei welchem der Verlauf des Dichtungswulstes freier gestaltbar und insbesondere näher an die Befestigungsmittel-Durchtrittsöffnungen des Gehäusedeckels heran legbar ist und welcher insbesondere einfach an dem Gehäuse montierbar ist.

Diese Aufgabe wird bei einem Gehäusedeckel mit den Merkmalen des Oberbegriffs von Anspruch 1 erfindungsgemäß dadurch gelöst, dass mindestens eine der Befestigungsmittel-Durchtrittsöffnungen gestuft ausgebildet ist.

Bei dem erfindungsgemäßen Gehäusedeckel liegt im montierten Zustand des Gehäusedeckels, in welchem der Dichtungswulst zwischen dem Gehäusedeckel und dem mittels des Gehäusedeckels zu verschließenden Gehäuse verpresst wird, das Verformungsbegrenzungselement im Kraft-Hauptschluss und der Dichtungswulst in Kraft-Nebenschluss. Hierdurch wird eine übermäßige Verformung des Dichtungswulstes vermieden.

Der Befestigungsmittel-Durchtrittsöffnungs-Abschnitt des Verformungsbegrenzungselements ist vorzugsweise ganz oder zumindest teilweise durch einen Prägevorgang oder einen Tiefziehvorgang an einem Grundkörper des Gehäusedeckels erzeugt.

Das blattförmige oder blechförmige Ausgangsmaterial, aus welchem der Gehäusedeckel erzeugt wird, weist vorzugsweise eine Dicke oder Materialstärke von 2,0 mm oder mehr auf.

Durch die gestufte Ausbildung einer Befestigungsmittel-Durchtrittsöffnung wird das Einführen eines Befestigungsmittels, beispielsweise einer Befestigungsschraube, in die Befestigungsmittel-Durchtrittsöffnung und/oder das korrekte Anordnen und/oder Ausrichten des Befestigungsmittels, beispielsweise einer Befestigungsschraube, relativ zu einer Befestigungsmittel-Aufnahme, beispielsweise einem Gewindeloch, des Gehäuses, an welchem der Gehäusedeckel lösbar festgelegt werden soll, während der Montage des Gehäusedeckels an dem Gehäuse erleichtert.

Insbesondere kann vorgesehen sein, dass die Befestigungsmittel-Durchtrittsöffnung, um welche sich der mindestens eine Befestigungsmittel-Durchtrittsöffnungs-Abschnitt des Verformungsbegrenzungselements erstreckt, gestuft ausgebildet ist.

Besonders günstig ist es, wenn alle Befestigungsmittel-Durchtrittsöffnungen des Gehäusedeckels gestuft ausgebildet sind.

Vorzugsweise ist vorgesehen, dass die gestuft ausgebildete Befestigungsmittel-Durchtrittsöffnung einen im montierten Zustand des Gehäusedeckels dem Gehäuse zugewandten Zentrierabschnitt und einen im montierten Zustand des Gehäusedeckels dem Gehäuse abgewandten Einführabschnitt umfasst.

Der Einführabschnitt erleichtert das Einführen des Befestigungsmittels, beispielsweise einer Befestigungsschraube, in die Befestigungsmittel-Durchtrittsöffnung bei der Montage des Gehäusedeckels an dem Gehäuse.

Der Zentrierabschnitt ermöglicht es, das in die Befestigungsmittel-Durchtrittsöffnung eingeführte Befestigungsmittel, beispielsweise eine Befestigungsschraube, präzise in Bezug auf eine an dem Gehäuse vorgesehene Aufnahme für das Befestigungsmittel, beispielsweise ein Gewindeloch, zu zentrieren, was die Montage des Gehäuse an dem Gehäuse vereinfacht.

Vorzugsweise weist der Zentrierabschnitt einen Durchmesser dz auf, welcher kleiner ist als der Durchmesser d_{E} des Einführabschnitts.

Besonders günstig ist es, wenn die gestuft ausgebildete Befestigungsmittel-Durchtrittsöffnung einen zwischen dem Zentrierabschnitt und dem Einführabschnitt angeordneten und sich zum Zentrierabschnitt hin verjüngenden Verjüngungsabschnitt umfasst.

Dabei kann vorgesehen sein, dass der Verjüngungsabschnitt im Wesentlichen kegelstumpfförmig ausgebildet ist.

Bei einer besonderen Ausgestaltung des erfindungsgemäßen Gehäusedeckels ist vorgesehen, dass der Befestigungsmittel-Durchtrittsöffnungs-Abschnitt des Verformungsbegrenzungselements sich über einen Umfangswinkel α von 360° um die Befestigungsmittel-Durchtrittsöffnung herum erstreckt.

Der Befestigungsmittel-Durchtrittsöffnungs-Abschnitt des Verformungsbegrenzungselement kann einteilig ausgebildet sein oder mehrere Teilelemente umfassen, die längs der Umfangsrichtung der Befestigungsmittel-Durchtrittsöffnung aufeinander folgen und längs der Umfangsrichtung der Befestigungsmittel-Durchtrittsöffnung voneinander beabstandet sind.

Eine Breite B des Befestigungsmittel-Durchtrittsöffnungs-Abschnitts des Verformungsbegrenzungselements ist definiert als die Ausdehnung des Befestigungsmittel-Durchtrittsöffnungs-Abschnitts des Verformungsbegrenzungselements in der Radialrichtung der Längsmittelachse der jeweiligen Befestigungsmittel-Durchtrittsöffnung, und zwar im Bereich einer Anlagefläche, mit welcher der Gehäusedeckel im montierten Zustand an dem Gehäuse anliegt.

Vorzugsweise ist diese Anlagefläche im Wesentlichen parallel zu der Dichtungstragefläche des Gehäusedeckels ausgerichtet.

Die Breite B des Befestigungsmittel-Durchtrittsöffnungs-Abschnitts des Verformungsbegrenzungselements kann längs der Umfangsrichtung der betreffenden Befestigungsmittel-Durchtrittsöffnung konstant sein oder variieren.

Wenn die Breite B des Befestigungsmittel-Durchtrittsöffnungs-Abschnitts des Verformungsbegrenzungselements längs der Umfangsrichtung der Befestigungsmittel-Durchtrittsöffnung variiert, so ist vorzugsweise vorgesehen, dass die Breite B des Befestigungsmittel-Durchtrittsöffnungs-Abschnitts mit abnehmendem Abstand von dem Dichtungswulst abnimmt.

In diesem Fall weist der Befestigungsmittel-Durchtrittsöffnungs-Abschnitt des Verformungsbegrenzungselements vorzugsweise an der Stelle seines Umfangs, an welcher er von dem Dichtungswulst den geringsten Abstand aufweist, die minimale Breite B1 auf.

An derjenigen Stelle seines Umfangs, welche von dem Dichtungswulst den größten Abstand aufweist, weist der Befestigungsmittel-Durchtrittsöffnungs-Abschnitt des Verformungsbegrenzungselements vorzugsweise die maximale Breite B2 auf.

Vorzugsweise ist B2 um mehr als 10 %, insbesondere um mehr als 30 %, besonders bevorzugt um mehr als 50 %, größer als B1.

Der Abstand einer Stelle des Umfangs des Befestigungsmittel-Durchtrittsöffnungs-Abschnitts des Verformungsbegrenzungselements von dem Dichtungswulst wird längs einer Geraden bestimmt, welche senkrecht zur Längsrichtung des Dichtungswulstes ausgerichtet ist, durch die betreffende Stelle des Umfangs des Befestigungsmittel-Durchtrittsöffnungs-Abschnitts verläuft und in der Ebene der Dichtungstragefläche liegt.

Dadurch, dass der Befestigungsmittel-Durchtrittsöffnungs-Abschnitt vorzugsweise auf seiner dem Dichtungswulst zugewandten Seite die geringste Breite B1 aufweist, kann der Dichtungswulst besonders nahe an die Befestigungsmittel-Durchtrittsöffnung heran gelegt werden.

Wie bereits erwähnt, kann bei einer besonderen Ausgestaltung des erfindungsgemäßen Gehäusedeckels vorgesehen sein, dass der Befestigungsmittel-Durchtrittsöffnungs-Abschnitt des Verformungsbegrenzungselements mehrere Teilelemente umfasst, die längs der Umfangsrichtung der Befestigungsmittel-Durchtrittsöffnung voneinander beabstandet sind.

Durch eine solche Aufteilung des Befestigungsmittel-Durchtrittsöffnungs-Abschnitts des Verformungsbegrenzungselements in mehrere Teilelemente, deren jeweilige Größe, Gestalt und Positionierung relativ zueinander und relativ zu der Befestigungsmittel-Durchtrittsöffnung sowie relativ zu dem Dichtungswulst frei wählbar sind, kann die Verspannungskraft, mit welcher der Gehäusedeckel gegen das Gehäuse verspannt ist, in gewünschter Weise variabel auf die einzelnen Teilelemente des Verformungsbegrenzungselements und auf den Dichtungswulst aufgeteilt werden.

Hierdurch ist es möglich, eine sichere und zuverlässige Abdichtung des Gehäusedeckels zu erzielen, ohne den Dichtungswulst übermäßig zu verpressen.

Der Umfangswinkel α, um welchen sich der Befestigungsmittel-Durchtrittsöffnungs-Abschnitt des Verformungsbegrenzungselements um die betreffende Befestigungsmittel-Durchtrittsöffnung herum erstreckt, wird in Bezug auf die Längsmittelachse der jeweiligen Befestigungsmittel-Durchtrittsöffnung bestimmt.

Dieser Umfangswinkel α beträgt vorzugsweise mehr als 90°, insbesondere mehr als 120°, besonders bevorzugt mehr als 150°, beispielsweise ungefähr 160°.

Ferner beträgt der Umfangswinkel α, um den sich der Befestigungsmittel-Durchtrittsöffnungs-Abschnitt des Verformungsbegrenzungselements um die jeweils zugeordnete Befestigungsmittel-Durchtrittsöffnung herum erstreckt und der in Bezug auf die Längsmittelachse der jeweiligen Befestigungsmittel-Durchtrittsöffnung bestimmt wird, insbesondere bei einem mehrere Teilelemente umfassenden Befestigungsmittel-Durchtrittsöffnungs-Abschnitt vorzugsweise weniger als 270°, insbesondere weniger als 200°, besonders bevorzugt höchstens 160°.

Mindestens eines der Teilelemente eines solchen Befestigungsmittel-Durchtrittsöffnungs-Abschnitts des Verformungsbegrenzungselements erstreckt sich vorzugsweise um einen Umfangswinkel β, der in Bezug auf die Längsmittelachse der jeweiligen Befestigungsmittel-Durchtrittsöffnung bestimmt wird, von weniger als 70°, insbesondere von weniger als 60°, besonders bevorzugt von weniger als 45°, beispielsweise von weniger als 30°, bei einer besonderen Ausgestaltung von weniger als 10°.

Insbesondere kann vorgesehen sein, dass alle Teilelemente des Befestigungsmittel-Durchtrittsöffnungs-Abschnitts des Verformungsbegrenzungselements sich über einen Umfangswinkel β von weniger als 70°, insbesondere von weniger als 60°, besonders bevorzugt von weniger als 45°, beispielsweise von weniger als 30°, bei einer besonderen Ausgestaltung von weniger als 10°, erstrecken.

Bei bevorzugten Ausgestaltungen der Erfindung ist vorgesehen, dass zwischen jeweils zwei Teilelementen, die längs der Umfangsrichtung der Befestigungsmittel-Durchtrittsöffnung aufeinander folgen, eine Lücke angeordnet ist und mindestens eine der Lücken sich über einen Umfangswinkel von mehr als 5°, insbesondere von mehr als 7°, besonders bevorzugt von mehr als 10°, erstreckt.

Vorzugsweise ist vorgesehen, dass alle Lücken zwischen jeweils zwei Teilelementen, die längs der Umfangsrichtung der Befestigungsmittel-Durchtrittsöffnung aufeinander folgen, sich jeweils über einen Umfangswinkel γ von mehr als 5°, insbesondere von mehr als 7°, besonders bevorzugt von mehr als 10°, erstrecken.

Bei einer bevorzugten Ausgestaltung der Erfindung ist vorgesehen, dass der Gehäusedeckel einen Grundkörper, insbesondere eine Grundplatte, umfasst und mindestens eines der Teilelemente durch Umformung, vorzugsweise Prägeformung, des Grundkörpers gebildet ist.

Vorzugsweise sind alle Teilelemente des Befestigungsmittel-Durchtrittsöffnungs-Abschnitts des Verformungsbegrenzungselements durch Umformung, vorzugsweise Prägeformung, des Grundkörpers gebildet.

Ferner kann vorgesehen sein, dass mindestens eine der Befestigungsmittel-Durchtrittsöffnungen eine gegenüber einer Hauptfläche des Gehäusedeckels vertiefte Befestigungsmittelkopf-Auflage umfasst.

Die Hauptfläche ist vorzugsweise auf der der Dichtungstragefläche abgewandten Seite des Gehäusedeckels angeordnet.

Die Hauptfläche des Gehäusedeckels ist vorzugsweise im Wesentlichen senkrecht zu den Längsmittelachsen der Befestigungsmittel-Durchtrittsöffnungen und/oder im Wesentlichen parallel zu der Dichtungstragefläche ausgerichtet.

Die vertiefte Befestigungsmittel-Auflage umfasst eine relativ zu der Hauptfläche des Gehäusedeckels in Richtung auf das Gehäuse versetzte Befestigungsmittelkopf-Auflagefläche, an welcher ein Kopf des Befestigungsmittels im montierten Zustand des Gehäusedeckels, vorzugsweise flächig, anliegt.

Wenn der Befestigungsmittel-Durchtrittsöffnungs-Abschnitt des Verformungsbegrenzungselements aus mehreren Teilelementen gebildet ist, so können diese Teilelemente grundsätzlich eine beliebig geformte Außenkontur aufweisen.

Als günstig hat sich erwiesen, wenn mindestens eines der Teilelemente eine als ein Kreissektorabschnitt ausgebildete Außenkontur aufweist.

Vorzugsweise weisen alle Teilelemente des Befestigungsmittel-Durchtrittsöffnungs-Abschnitts des Verformungsbegrenzungselements jeweils eine als ein Kreissektorabschnitt ausgebildete Außenkontur auf.

Die vorliegende Erfindung betrifft ferner ein Verfahren zum Herstellen eines Gehäusedeckels zum Festlegen an einem Gehäuse, wobei der Gehäusedeckel mehrere Befestigungsmittel-Durchtrittsöffnungen und einen Dichtungswulst, welcher an einer Dichtungstragefläche des Gehäusedeckels angeordnet ist, umfasst.

Der vorliegenden Erfindung liegt die weitere Aufgabe zugrunde, ein Verfahren zum Herstellen eines solchen Gehäusedeckels zu schaffen, bei welchem der Verlauf des Dichtungswulstes freier gestaltbar und insbesondere näher an die Befestigungsmittel-Durchtrittsöffnungen des Gehäusedeckels heran legbar ist und bei welchem insbesondere der Gehäusedeckel in einfacher Weise an dem Gehäuse montierbar ist.

Diese Aufgabe wird erfindungsgemäß gelöst durch ein Verfahren zum Herstellen eines Gehäusedeckels zum Festlegen an einem Gehäuse,
wobei der Gehäusedeckel
mehrere Befestigungsmittel-Durchtrittsöffnungen,
einen Dichtungswulst, welcher an einer Dichtungstragefläche des Gehäusedeckels angeordnet ist, und
mindestens ein Verformungsbegrenzungselement, welches über die Dichtungstragefläche in derselben Richtung vorsteht wie der Dichtungswulst und eine Verformung des Dichtungswulstes im montierten Zustand des Gehäusedeckels begrenzt, umfasst und
wobei das Verformungselement mindestens einen Befestigungsmittel-Durchtrittsöffnungs-Abschnitt umfasst, der sich längs einer Umfangsrichtung einer der Befestigungsmittel-Durchtrittsöffnungen über einen Umfangswinkel α um die betreffende Befestigungsmittel-Durchtrittsöffnung erstreckt, und wobei mindestens eine der Befestigungsmittel-Durchtrittsöffnungen gestuft ausgebildet ist,
wobei das Verfahren Folgendes umfasst:
   - Einprägen einer gestuften Begrenzungswand mindestens einer Befestigungsmittel-Durchtrittsöffnung in den Grundkörper des Gehäusedeckels;
   - Heraustrennen der Befestigungsmittel-Durchtrittsöffnung aus dem Grundkörper des Gehäusedeckels.

Weitere besondere Ausgestaltungen des erfindungsgemäßen Verfahrens sind bereits vorstehend im Zusammenhang mit besonderen Ausgestaltungen des erfindungsgemäßen Gehäusedeckels erläutert worden.

Das erfindungsgemäße Verfahren zum Herstellen eines Gehäusedeckels eignet sich insbesondere zur Herstellung des erfindungsgemäßen Gehäusedeckels.

Der erfindungsgemäße Gehäusedeckel eignet sich insbesondere als Bestandteil einer Baugruppe, welche den Gehäusedeckel, das Gehäuse, an welchem der Gehäusedeckel festgelegt werden soll, und mehrere Befestigungsmittel zum - vorzugsweise lösbaren - Festlegen des Gehäusedeckels an dem Gehäuse umfasst.

Wenn der Gehäusedeckel eine vertiefte Befestigungsmittelkopf-Auflage aufweist, so wird im Bereich der Befestigungsmittel-Durchtrittsöffnung vorzugsweise die Befestigungsmittelkopf-Auflagefläche für den Kopf des Befestigungsmittels über einen Prägevorgang im Wesentlichen vollflächig abgesenkt.

Auf der der vertieften Befestigungsmittelkopf-Auflage gegenüberliegenden Seite des Gehäusedeckels wird der Befestigungsmittel-Durchtrittsöffnungs-Abschnitt des Verformungsbegrenzungselements ausgeprägt, und das überschüssige Material wird im Bauteil verdrängt oder abgetrennt, beispielsweise durch Ausstanzen.

Bei Verwendung des erfindungsgemäßen Gehäusedeckels wird ein Verkippen des Befestigungsmittels und des Gehäusedeckels nach innen verhindert.

Der für das Festlegen des Gehäusedeckels an dem Gehäuse benötigte Kraftschluss des Befestigungsmittels, beispielsweise einer Befestigungsschraube, wird über den Gehäusedeckel in einen Befestigungsmittel-Montagebereich, beispielsweise einen Flanschbereich, des Gehäuses geleitet.

Die Verpressung des Dichtungswulstes, beispielsweise in Form einer CIP("Cured In Place")-Raupe, auf die Höhe des Verformungsbegrenzungselements über der Dichtungstragefläche des Gehäusedeckels in dem Kraft-Nebenschluss wird sichergestellt.

Der Dichtungswulst kann sehr nahe an die Befestigungsmittel-Durchtrittsöffnung heran gelegt werden, so dass auch der Befestigungsmittel-Montagebereich, beispielsweise der Flanschbereich, des Gehäuses schmal gehalten werden kann.

Das Ausgangsmaterial, aus welchem der Gehäusedeckel hergestellt wird, ist vorzugsweise ein blechförmiges Material.

Ferner ist das Ausgangsmaterial vorzugsweise ein metallisches Material.

Beispielsweise kann das Ausgangsmaterial Aluminium umfassen, insbesondere als Hauptbestandteil.

Das Ausgangsmaterial kann eine Aluminiumlegierung sein.

Ferner kann vorgesehen sein, dass das Ausgangsmaterial ein Stahlmaterial, vorzugsweise ein Edelstahlmaterial, ist.

Der Dichtungswulst kann als eine CIP("Cured In Place")-Dichtraupe ausgebildet sein oder durch Siebdruck an der Dichtungstragefläche des Gehäusedeckels erzeugt sein.

Das Gehäuse, welches mittels des Gehäusedeckels verschließbar ist, kann beispielsweise ein Gehäuse einer Steuervorrichtung und/oder eines Bestandteils eines Elektroantriebs, insbesondere eines Elektroantriebs für ein Elektro-Automobil, sein.

Weitere Merkmale und Vorteile der Erfindung sind Gegenstand der nachfolgenden Beschreibung und der zeichnerischen Darstellung von Ausführungsbeispielen.

In den Zeichnungen zeigen:

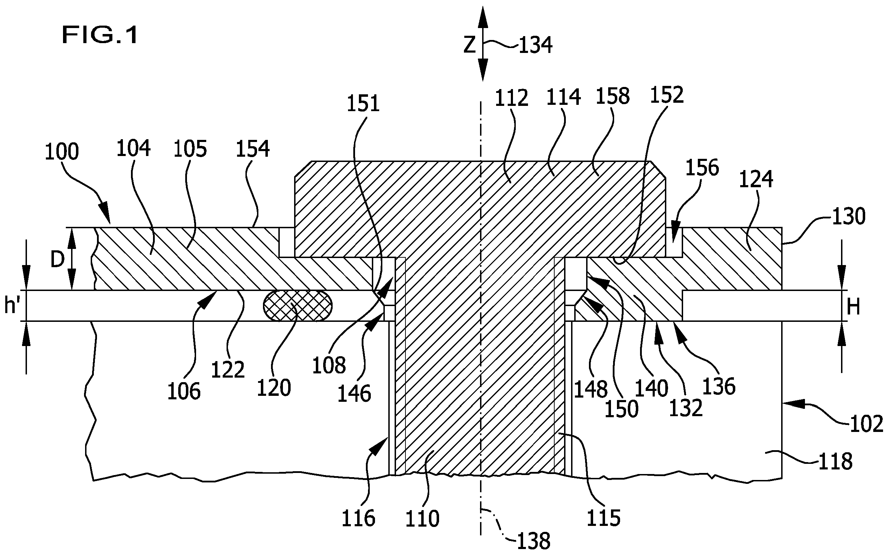

- Fig. 1: einen Schnitt durch einen Randbereich eines Gehäusedeckels, der mittels eines Befestigungsmittels an einem Gehäuse festgelegt ist, wobei der Gehäusedeckel eine Befestigungsmittel-Durchtrittsöffnung, einen Dichtungswulst und ein Verformungsbegrenzungselement zur Begrenzung einer Verformung des Dichtungswulstes im montierten Zustand des Gehäusedeckels umfasst, wobei das Verformungsbegrenzungselement in einem Befestigungsmittel-Durchtrittsöffnungs-Abschnitt desselben in mehrere Teilelemente unterteilt ist, die längs der Umfangsrichtung der Befestigungsmittel-Durchtrittsöffnung aufeinander folgen und längs der Umfangsrichtung voneinander beabstandet sind, wobei die Befestigungsmittel-Durchtrittsöffnung gestuft ausgebildet ist und eine vertiefte Befestigungsmittelkopf-Auflage, einen Einführabschnitt, einen Verjüngungsabschnitt und einen Zentrierabschnitt aufweist;

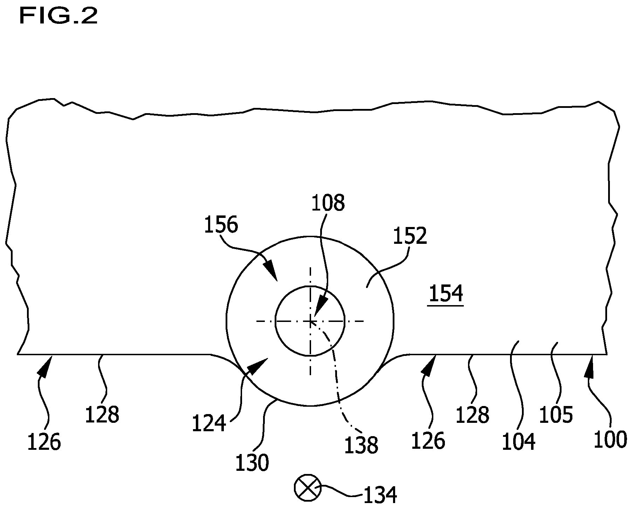

- Fig. 2: eine Draufsicht auf den Randbereich des Gehäusedeckels von oben, mit der Blickrichtung auf eine im montierten Zustand des Gehäusedeckels dem Gehäuse abgewandte Hauptfläche des Gehäusedeckels, längs des Pfeiles 2 in Fig. 1;

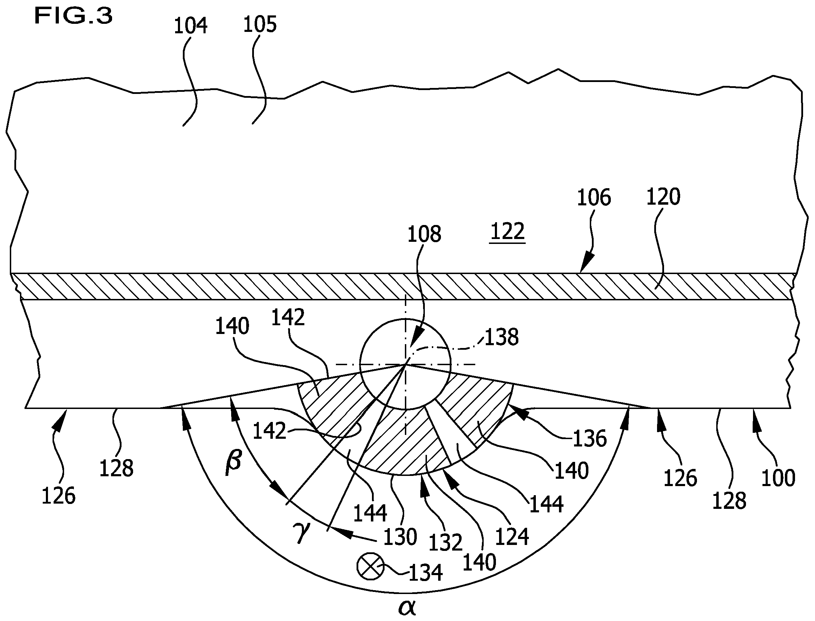

- Fig. 3: eine Draufsicht auf den Randbereich des Gehäusedeckels von unten, mit der Blickrichtung auf eine im montierten Zustand des Gehäusedeckels dem Gehäuse zugewandte Dichtungstragefläche des Gehäusedeckels, längs des Pfeiles 3 in Fig. 1;

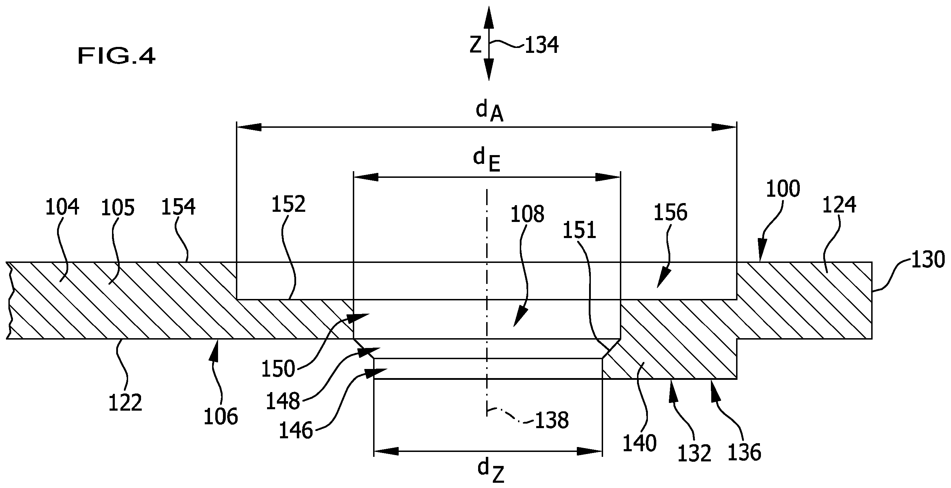

- Fig. 4: einen Schnitt durch einen Randbereich eines Grundkörpers des Gehäusedeckels aus den Fig. 1 bis 3 in einem Befestigungsmittel-Durchtrittsöffnungs-Bereich des Gehäusedeckels, in welchem eine Befestigungsmittel-Durchtrittsöffnung angeordnet ist;

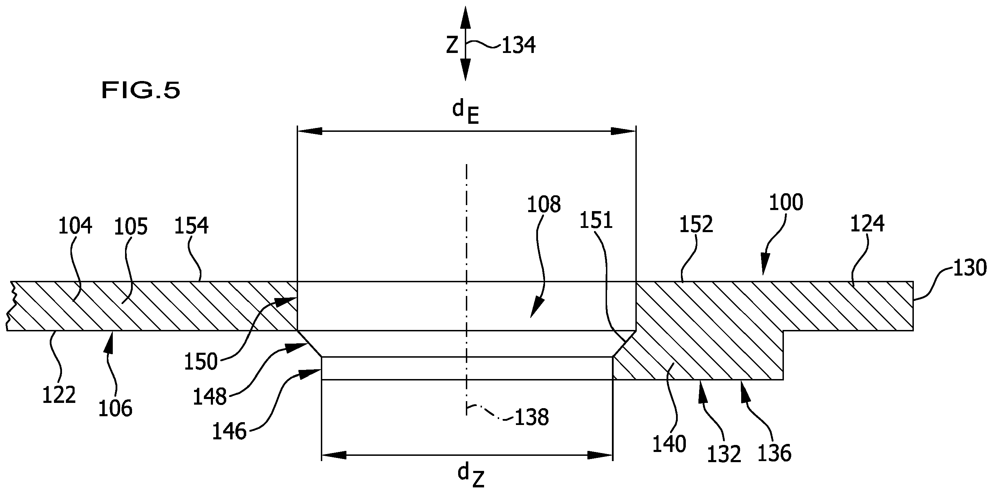

- Fig. 5: einen Schnitt durch einen Randbereich eines Grundkörpers einer zweiten Ausführungsform des Gehäusedeckels in einem Befestigungsmittel-Durchtrittsöffnungs-Bereich, in dem eine Befestigungsmittel-Durchtrittsöffnung angeordnet ist, wobei die Befestigungsmittel-Durchtrittsöffnung keine vertiefte Befestigungsmittelkopf-Auflage aufweist, sondern ein Einführabschnitt der Befestigungsmittel-Durchtrittsöffnung unmittelbar an einer im montierten Zustand des Gehäusedeckels dem Gehäuse abgewandten Hauptfläche des Gehäusedeckels mündet;

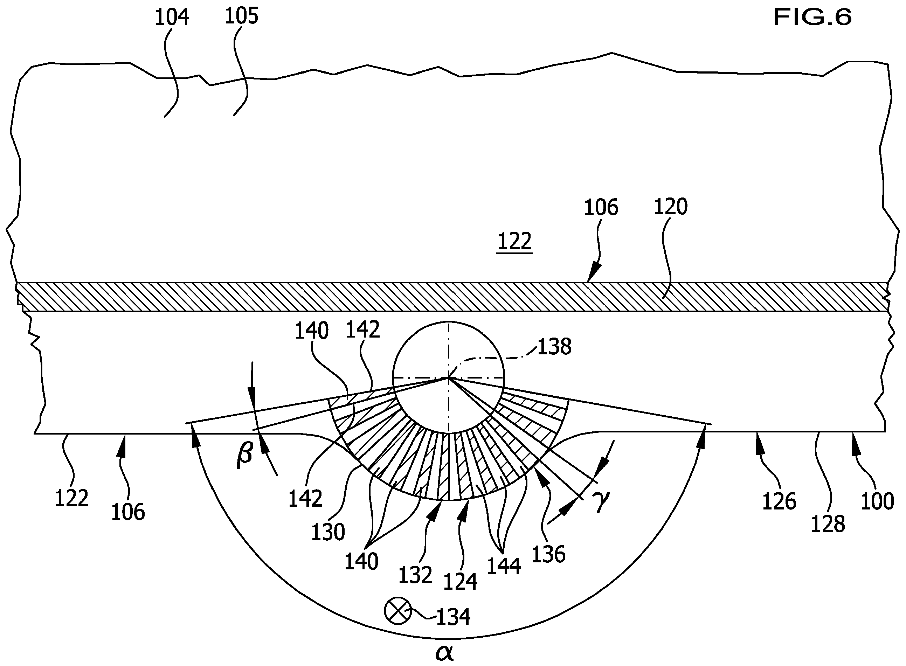

- Fig. 6: eine der Fig. 3 entsprechende Draufsicht auf den Randbereich einer dritten Ausführungsform eines Gehäusedeckels, bei welcher die Teilelemente des Befestigungsmittel-Durchtrittsöffnungs-Abschnitts des Verformungsbegrenzungselements zahlreicher sind und schmaler ausgebildet sind als bei der ersten Ausführungsform, mit der Blickrichtung auf eine im montierten Zustand des Gehäusedeckels dem Gehäuse zugewandte Dichtungstragefläche des Gehäusedeckels;

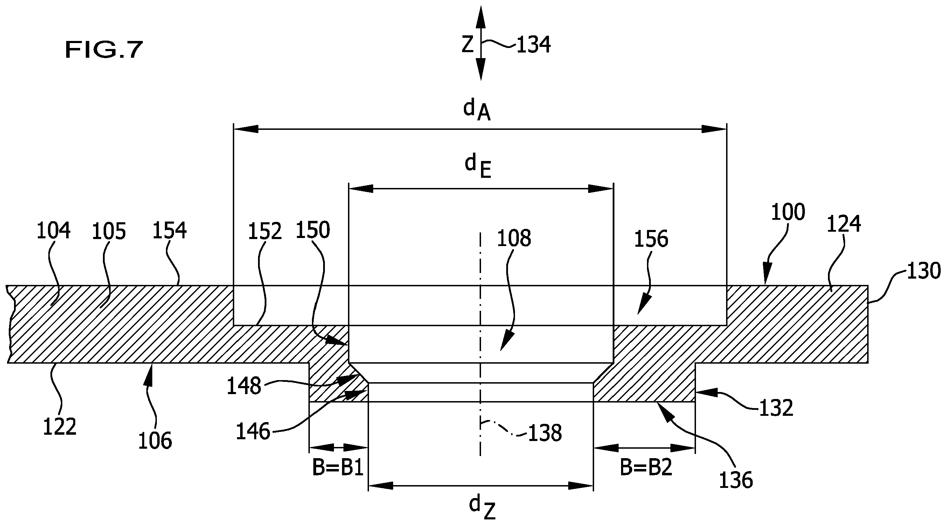

- Fig. 7: einen der Fig. 4 entsprechenden Schnitt durch einen Randbereich eines Grundkörpers einer vierten Ausführungsform eines Gehäusedeckels, bei welcher der Befestigungsmittel-Durchtrittsöffnungs-Abschnitt des Verformungsbegrenzungselements einteilig ausgebildet ist, sich über einen Umfangswinkel α von 360° um die Befestigungsmittel-Durchtrittsöffnung herum erstreckt und auf der dem Dichtungswulst zugewandten Seite der Befestigungsmittel-Durchtrittsöffnung eine geringere Breite aufweist als auf der dem Dichtungswulst abgewandten Seite der Befestigungsmittel-Durchtrittsöffnung, wobei die Befestigungsmittel-Durchtrittsöffnung eine vertiefte Befestigungsmittelkopf-Auflage aufweist; und

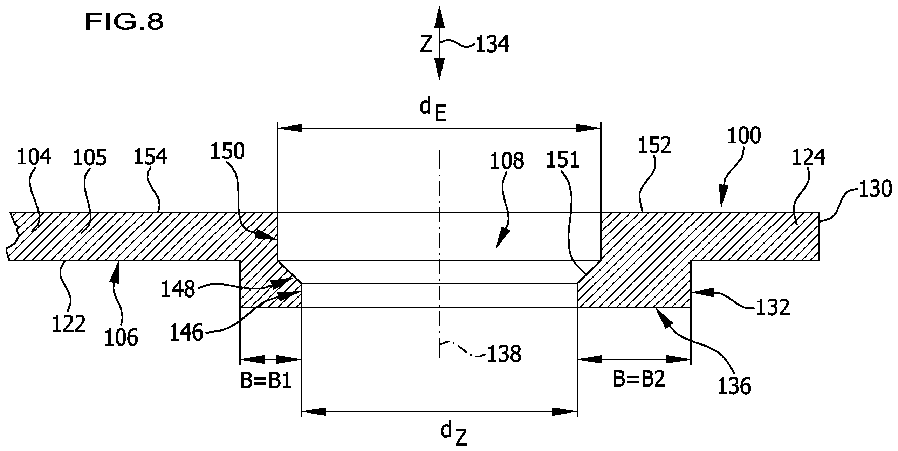

- Fig. 8: einen der Fig. 7 entsprechenden Schnitt durch einen Randbereich eines Grundkörpers einer fünften Ausführungsform des Gehäusedeckels, bei welcher die Befestigungsmittel-Durchtrittsöffnung keine vertiefte Befestigungsmittelkopf-Auflage aufweist, sondern ein Einführabschnitt der Befestigungsmittel-Durchtrittsöffnung unmittelbar an einer im montierten Zustand des Gehäusedeckels dem Gehäuse abgewandten Hauptfläche des Gehäusedeckels mündet.

Gleiche oder funktional äquivalente Elemente sind in allen Figuren mit denselben Bezugszeichen bezeichnet.

Ein in den Fig. 1 bis 4 ausschnittsweise dargestellter, als Ganzes mit 100 bezeichneter Gehäusedeckel ist zum Verschließen einer Gehäuseöffnung an einem Gehäuse 102, beispielsweise an einem Gehäuse einer Steuervorrichtung oder eines Wechselrichters, insbesondere eines Wechselrichters einer Antriebsvorrichtung für ein Elektro-Automobil, vorgesehen.

Der in den Zeichnungen beispielhaft dargestellte Gehäusedeckel 100 umfasst einen Grundkörper 104, beispielsweise in Form einer metallischen Grundplatte 105, der einen Dichtungstragebereich 106 umfasst.

Längs des äußeren Umfangs des Dichtungstragebereichs 106 des Gehäusedeckels 100 ist der Gehäusedeckel 100 mit mehreren Befestigungsmittel-Durchtrittsöffnungen 108 versehen, welche längs des Umfangs des Gehäusedeckels 100 im Abstand voneinander aufeinanderfolgen.

Diese Befestigungsmittel-Durchtrittsöffnungen 108 dienen bei der Montage des Gehäusedeckels 100 an dem zu verschließenden Gehäuse 102 zur Aufnahme der Schäfte 110 von Befestigungsmitteln 112, vorzugsweise in Form von Befestigungsschrauben 114 (siehe die Fig. 1, welche den Gehäusedeckel 100 in seinem mittels der Befestigungsmittel 112 an dem Gehäuse 102 montierten Zustand darstellt), welche sich durch die Befestigungsmittel-Durchtrittsöffnungen 108 hindurch erstrecken und mit ihren Außengewinden 115 in korrespondierende Innengewinde von Gewindelöchern 116 in Befestigungsmittel-Montagebereichen 118 des zu verschließenden Gehäuses 102 eingeschraubt werden.

Eine oder mehrere der Befestigungsmittel-Durchtrittsöffnungen 108 sind vorzugsweise zumindest teilweise in jeweils einem Befestigungsmittel-Durchtrittsöffnungs-Bereich 124 des Gehäusedeckels 100 angeordnet, welcher zwischen zwei Zwischen-Befestigungsmittel-Durchtrittsöffnungs-Bereichen 126 des Gehäusedeckels 100 angeordnet ist und welcher über einen äußeren Rand 128 der angrenzenden Zwischen-Befestigungsmittel-Durchtrittsöffnungs-Bereiche 126 nach außen vorspringt. Der äußere Rand 130 des Befestigungsmittel-Durchtrittsöffnungs-Bereichs 124 verläuft vorzugsweise im Wesentlichen längs der Umfangsrichtung der jeweiligen Befestigungsmittel-Durchtrittsöffnung 108.

Zur fluiddichten Abdichtung zwischen dem Gehäusedeckel 100 und dem zu verschließenden Gehäuse 102 ist ein Dichtungswulst 120 vorgesehen, welcher an einer im montierten Zustand des Gehäusedeckels 100 dem Innenraum des zu verschließenden Gehäuses 102 zugewandten Innenseite des Gehäusedeckels 100, welche eine Dichtungstragefläche 122 des Gehäusedeckels 100 bildet, angeordnet ist.

Der Dichtungswulst 120 verläuft längs des Randes des Gehäusedeckels 100 und ist vorzugsweise ringförmig geschlossen ausgebildet.

Der Dichtungswulst 120 ist aus einem Elastomermaterial, beispielsweise aus einem Silikonmaterial, gebildet und kann beispielsweise durch Auftragen mittels eines Dispensers (in einem sogenannten CIP("Cured-in-Place")-Verfahren) oder durch ein Siebdruckverfahren an der Dichtungstragefläche 122 gebildet werden.

Bei der Montage des Gehäusedeckels 100 an dem Gehäuse 102 mittels der Befestigungsmittel 112 wird durch Anziehen der Befestigungsmittel 112 in den Gewindelöchern 116 der Befestigungsmittel-Montagebereiche 118 des Gehäuses 102 der Dichtungswulst 120 verpresst, wobei sich die Höhe des Dichtungswulstes 120, das heißt dessen Ausdehnung senkrecht zu der Dichtungstragefläche 122, von der Höhe h im unbelasteten Zustand auf einen Wert h' im montierten Zustand verringert.

Die elastische Rückstellkraft des elastomeren Dichtungswulstes 120 erzeugt dann die Abdichtkraft, mit welcher der Dichtungswulst 120 abdichtend an dem Gehäuse 102 anliegt.

Um eine übermäßige Verformung des Dichtungswulstes 120 zu vermeiden, umfasst der Gehäusedeckel 100 ein oder mehrere Verformungsbegrenzungselemente 132, welche über die Dichtungstragefläche 122 in derselben Richtung, nämlich in einer senkrecht zur Dichtungstragefläche 122 ausgerichteten Z-Richtung 134, vorstehen wie der Dichtungswulst 120 und eine Verformung des Dichtungswulstes 120 im montierten Zustand des Gehäusedeckels 100 begrenzen.

Das Verformungsbegrenzungselement 132 ist steifer als der Dichtungswulst 120 ausgebildet, vorzugsweise im Wesentlichen starr, so dass die Höhe h' des Dichtungswulstes 120 im verpressten Zustand desselben nach unten durch die Höhe H des Verformungsbegrenzungselements 132 über der Dichtungstragefläche 122 begrenzt ist.

Mindestens eines der Verformungsbegrenzungselemente 132 umfasst einen Befestigungsmittel-Durchtrittsöffnungs-Abschnitt 136, der sich längs einer Umfangsrichtung einer jeweils zugeordneten Befestigungsmittel-Durchtrittsöffnung 108 über einen Umfangswinkel α um die betreffende Befestigungsmittel-Durchtrittsöffnung 108 herum erstreckt (siehe Fig. 3).

Der Umfangswinkel α wird in Bezug auf eine Längsmittelachse 138 der Befestigungsmittel-Durchtrittsöffnung 108 bestimmt, welche sich parallel zu der Z-Richtung 134 durch die Mitte der Befestigungsmittel-Durchtrittsöffnung 108 erstreckt.

Der Umfangswinkel α beträgt vorzugsweise mehr als 90°, insbesondere mehr als 120°, besonders bevorzugt mehr als 150°.

Ferner beträgt der Umfangswinkel β vorzugsweise weniger als 270°, insbesondere weniger als 180°, besonders bevorzugt beispielsweise ungefähr 160° oder weniger als 160°.

Der Befestigungsmittel-Durchtrittsöffnungs-Abschnitt 136 des Verformungsbegrenzungselements 132 umfasst mehrere, vorzugsweise zwei oder mehr, im dargestellten Ausführungsbeispiel drei, Teilelemente 140, die längs der Umfangsrichtung der Befestigungsmittel-Durchtrittsöffnung 108 voneinander beabstandet sind.

Dabei ist vorzugsweise vorgesehen, dass mindestens eines der Teilelemente 140 des Befestigungsmittel-Durchtrittsöffnungs-Abschnitts 136 sich über einen Umfangswinkel β, bezogen auf die Längsmittelachse 138 der Befestigungsmittel-Durchtrittsöffnung 108, von weniger als 70°, insbesondere von weniger als 60°, besonders bevorzugt von weniger als 45°, beispielsweise von ungefähr 40°, erstreckt.

Ferner ist vorzugsweise vorgesehen, dass mindestens eines der Teilelemente 140 des Befestigungsmittel-Durchtrittsöffnungs-Abschnitts 136 des Verformungsbegrenzungselements 132 sich über einen Umfangswinkel β von mehr als 5°, insbesondere von mehr als 10°, besonders bevorzugt von mehr als 30°, beispielsweise von ungefähr 40°, erstreckt.

Die Teilelemente können beispielsweise als jeweils ein Kreissektorabschnitt ausgebildet sein und vorzugsweise im Wesentlichen radial zur Längsmittelachse 138 der Befestigungsmittel-Durchtrittsöffnung 108 verlaufende seitliche Ränder 142 aufweisen.

Die Umfangswinkel β, über welche sich die Teilelemente 140 des Befestigungsmittel-Durchtrittsöffnungs-Abschnitts 136 des Verformungsbegrenzungselements 132 jeweils erstrecken, können einander im Wesentlichen gleich sein oder aber voneinander verschieden sein.

Zwischen jeweils zwei Teilelementen 140, die längs der Umfangsrichtung der Befestigungsmittel-Durchtrittsöffnung 108 aufeinander folgen, ist jeweils eine Lücke 144 angeordnet.

Mindestens eine der Lücken 144 erstreckt sich vorzugsweise über einen Umfangswinkel γ von mehr als 5°, insbesondere mehr als 7°, besonders bevorzugt mehr als 10°, beispielsweise von ungefähr 13°.

Ferner erstreckt sich vorzugsweise mindestens eine der Lücken 144 über einen Umfangswinkel γ von weniger als 30°, insbesondere von weniger als 20°, besonders bevorzugt von weniger als 15°.

Die Teilelemente 140 sind durch Prägeformung in den Grundkörper 104 des Gehäusedeckels 100 eingeformt.

Die Befestigungsmittel-Durchtrittsöffnung 108 ist vorzugsweise gestuft ausgebildet.

Bei der in den Fig. 1 bis 4 dargestellten Ausführungsform des Gehäusedeckels 100 ist vorgesehen, dass die Befestigungsmittel-Durchtrittsöffnung 108 einen im montierten Zustand des Gehäusedeckels 100 dem Gehäuse 102 zugewandten Zentrierabschnitt 146 umfasst.

Der Zentrierabschnitt 146 ist vorzugsweise im Wesentlichen kreiszylindrisch ausgebildet und weist einen Durchmesser dz auf.

Ferner umfasst die Befestigungsmittel-Durchtrittsöffnung 108 vorzugsweise einen sich an den Zentrierabschnitt 146 anschließenden und sich zu dem Zentrierabschnitt 146 hin verjüngenden Verjüngungsabschnitt 148.

Der Verjüngungsabschnitt 148 ist im Wesentlichen kreiskegelstumpfförmig ausgebildet und verjüngt sich von einem Durchmesser d_{E} an dem dem Zentrierabschnitt 146 abgewandten Ende des Verjüngungsabschnitts 148 bis zu dem Durchmesser dz an dem dem Zentrierabschnitt 146 zugewandten Ende des Verjüngungsabschnitts 148.

Ferner umfasst die Befestigungsmittel-Durchtrittsöffnung 108 einen sich an den Verjüngungsabschnitt 148 anschließenden Einführabschnitt 150.

Der Einführabschnitt 150 ist im Wesentlichen kreiszylinderförmig ausgebildet und weist den Durchmesser d_{E} auf.

Die Begrenzungsflächen am Umfang des Einführabschnitts 150, des Verjüngungsabschnitts 148 und des Zentrierabschnitts 146 bilden zusammen eine gestufte Begrenzungswand 151 der Befestigungsmittel-Durchtrittsöffnung 108.

Der Einführabschnitt 150 der Befestigungsmittel-Durchtrittsöffnung 108 mündet an einer Befestigungsmittelkopf-Auflagefläche 152, welche eine Begrenzung einer gegenüber einer Hauptfläche 154 des Gehäusedeckels 100 vertieften Befestigungsmittelkopf-Auflage 156 bildet.

Die Hauptfläche 154 des Gehäusedeckels 100 ist auf der der Dichtungstragefläche 122 abgewandten Seite des Gehäusedeckels 100 angeordnet.

Die Befestigungsmittelkopf-Auflage 156, der Einführabschnitt 150, der Verjüngungsabschnitt 148 und der Zentrierabschnitt 146 der Befestigungsmittel-Durchtrittsöffnung 108 sind jeweils konzentrisch zu der Längsmittelachse 138 der Befestigungsmittel-Durchtrittsöffnung 108 angeordnet.

Der Durchmesser dz des Zentrierabschnitts 146 ist kleiner als der Durchmesser d_{E} des Einführabschnitts 150.

Der Durchmesser d_{E} des Einführabschnitts 150 ist kleiner als der Durchmesser d_{A} der Befestigungsmittelkopf-Auflage 156.

Wie aus Fig. 1 zu ersehen ist, liegt der Kopf 158 des Befestigungsmittels 112 im montierten Zustand des Gehäusedeckels 100 flächig an der Befestigungsmittelkopf-Auflagefläche 152 der Befestigungsmittelkopf-Auflage 156 an.

Der Einführabschnitt 150 und der Verjüngungsabschnitt 148 der Befestigungsmittel-Durchtrittsöffnung 108 erleichtern das Einführen des Schaftes 110 des Befestigungsmittels 112 in die Befestigungsmittel-Durchtrittsöffnung 108 und von dort in das Gewindeloch 116 im Befestigungsmittel-Montagebereich 118 des Gehäuses 102.

Der Zentrierabschnitt 146 der Befestigungsmittel-Durchtrittsöffnung 108 zentriert den Schaft 110 des Befestigungsmittels 112 relativ zu der Längsmittelachse 138, so dass die Längsmittelachse des Befestigungsmittels 112 mit der Längsmittelachse 138 der Befestigungsmittel-Durchtrittsöffnung 108 zusammenfällt, und relativ zu dem Gewindeloch 116 in dem Befestigungsmittel-Montagebereich 118 des Gehäuses 102.

Der Gehäusedeckel 100 ist aus einem blattförmigen Ausgangsmaterial, insbesondere aus einem metallischen Blechmaterial, gebildet, das eine Materialstärke oder Dicke D aufweist, welche vorzugsweise größer ist als 1,5 mm, besonders bevorzugt größer ist als 2,0 mm.

Die Dicke D des Ausgangsmaterials des Gehäusedeckels 100 beträgt vorzugsweise weniger als 5,0 mm, besonders bevorzugt weniger als 3,0 mm.

Aus diesem Ausgangsmaterial wird der Gehäusedeckel 100 einschließlich des Verformungsbegrenzungselements 132 wie folgt hergestellt:
Die vertiefte Befestigungsmittelkopf-Auflage 156 und die gestufte Begrenzungswand 151 der Befestigungsmittel-Durchtrittsöffnung 108 werden in das Ausgangsmaterial geprägt.

Die Teilelemente 140 des Verformungsbegrenzungselements 132 werden ausgeformt.

Die Befestigungsmittel-Durchtrittsöffnung 108 wird aus dem Ausgangsmaterial herausgetrennt, beispielsweise ausgeschnitten, vorzugsweise mittels eines Lasers, oder ausgestanzt.

Der Dichtungswulst 120 wird durch Auftragen aus einem Dispenser oder durch Siebdruck an der Dichtungstragefläche 122 gebildet.

Durch das Verformungsbegrenzungselement 132, auch als Stopper bezeichnet, wird bei der Montage des Gehäusedeckels 100 an dem Gehäuse 102 der Dichtungswulst 120 auf das definierte Maß h' verpresst, welches der Höhe H des Verformungsbegrenzungselements 132 über der Dichtungstragefläche 122 entspricht.

Hierdurch wird ein Überpressen des Dichtungswulstes 120 verhindert.

Das metallische Ausgangsmaterial, aus welchem der Gehäusedeckel 100 hergestellt wird, kann insbesondere Aluminium oder eine Aluminium-Legierung umfassen.

Alternativ hierzu kann auch vorgesehen sein, dass das Ausgangsmaterial, aus welchem der Gehäusedeckel 100 gebildet wird, ein Edelstahlmaterial ist.

Grundsätzlich kommt aber auch jedes andere blechförmige, insbesondere metallische, Ausgangsmaterial für die Herstellung des Gehäusedeckels 100 in Betracht.

Eine in Fig. 5 ausschnittsweise dargestellte zweite Ausführungsform eines Gehäusedeckels 100 unterscheidet sich von der vorstehend beschriebenen, in den Fig. 1 bis 4 dargestellten ersten Ausführungsform dadurch, dass die Befestigungsmittel-Durchtrittsöffnung 108 bei dieser zweiten Ausführungsform keine vertiefte Befestigungsmittelkopf-Auflage 156 aufweist, sondern statt dessen der Einführabschnitt 150 der Befestigungsmittel-Durchtrittsöffnung 108 unmittelbar an der Hauptfläche 154 des Gehäusedeckels 100 mündet, welche bei dieser Ausführungsform zugleich als Befestigungsmittelkopf-Auflagefläche 152 dient.

Bei dieser Ausführungsform liegt im montierten Zustand des Gehäusedeckels 100 der Kopf 158 des Befestigungsmittels 112 an der als Befestigungsmittelkopf-Auflagefläche 152 dienenden Hauptfläche 154 des Gehäusedeckels 100 an.

Diese Ausführungsform des Gehäusedeckels 100 ohne eine vertiefte Befestigungsmittelkopf-Auflage 156 wird vorzugsweise dann verwendet, wenn die Dicke oder Materialstärke des Ausgangsmaterials geringer ist als 3,0 mm.

Bei der Herstellung der zweiten Ausführungsform des Gehäusedeckels 100 wird wie folgt vorgegangen:
Die gestufte Begrenzungswand 151 der Befestigungsmittel-Durchtrittsöffnung 108 und die Teilelemente 140 des Verformungsbegrenzungselements 132 werden in das Ausgangsmaterial eingeprägt.

Der Zentrierabschnitt 146 der Befestigungsmittel-Durchtrittsöffnung 108 wird aus dem Ausgangsmaterial herausgetrennt, beispielsweise ausgeschnitten, vorzugsweise mittels eines Lasers, oder ausgestanzt.

Der Dichtungswulst 120 wird an der Dichtungstragefläche 122 des Gehäusedeckels 100 durch Auftrag aus einem Dispenser oder durch Siebdruck erzeugt.

Im Übrigen stimmt die in Fig. 5 dargestellte zweite Ausführungsform eines Gehäusedeckels 100 hinsichtlich Aufbau, Funktion und Herstellungsweise mit der in den Fig. 1 bis 4 dargestellten ersten Ausführungsform überein, auf deren vorstehende Beschreibung insoweit Bezug genommen wird.

Eine in Fig. 6 ausschnittsweise dargestellte dritte Ausführungsform eines Gehäusedeckels 100 unterscheidet sich von der vorstehend beschriebenen, in den Fig. 1 bis 4 dargestellten ersten Ausführungsform dadurch, dass der Befestigungsmittel-Durchtrittsöffnungs-Abschnitt 136 des Verformungsbegrenzungselements 132 eine größere Anzahl von Teilelementen 140 aufweist, welche sich jeweils über einen kleineren Umfangswinkel β erstrecken.

Insbesondere kann vorgesehen sein, dass die Anzahl der Teilelemente 140 des Befestigungsmittel-Durchtrittsöffnungs-Abschnitts 136 des Verformungsbegrenzungselements 132 fünf oder mehr, insbesondere sieben oder mehr, besonders bevorzugt zehn oder mehr, beispielsweise dreizehn, beträgt.

Ferner ist vorzugsweise vorgesehen, dass mindestens eines der Teilelemente 140 des Befestigungsmittel-Durchtrittsöffnungs-Abschnitts 136 des Verformungsbegrenzungselements 132 sich über einen Umfangswinkel β, in Bezug auf die Längsmittelachse 138 der Befestigungsmittel-Durchtrittsöffnung 108, von weniger als 30°, insbesondere von weniger als 20°, besonders bevorzugt von weniger als 10°, beispielsweise von ungefähr 5°, erstreckt.

Die Lücken 144, welche jeweils zwischen zwei längs der Umfangsrichtung der Befestigungsmittel-Durchtrittsöffnung 108 aufeinander folgenden Teilelementen 140 angeordnet sind, erstrecken sich bei dieser Ausführungsform vorzugsweise über einen Umfangswinkel γ von weniger als 30°, insbesondere von weniger als 20°, besonders bevorzugt von weniger als 10°, beispielsweise von ungefähr 5°.

Bei dieser Ausführungsform sind die Teilelemente 140 des Verformungsbegrenzungselements 132 als sehr schmale Kreissegmentabschnitte ausgebildet, was ihnen ein strahlenförmiges Aussehen verleiht.

Der Befestigungsmittel-Durchtrittsöffnungs-Abschnitt 136 des Verformungsbegrenzungselements 132 hat daher bei dieser Ausführungsform einen strahlenkranzförmige Gestalt.

Im Übrigen stimmt die in Fig. 6 dargestellte dritte Ausführungsform eines Gehäusedeckels 100 hinsichtlich Aufbau, Funktion und Herstellungsweise mit der in den Fig. 1 bis 4 dargestellten ersten Ausführungsform überein, auf deren vorstehende Beschreibung insoweit Bezug genommen wird.

Ferner ist es auch bei der dritten Ausführungsform eines Gehäusedeckels 100 möglich, die vertiefte Befestigungsmittelkopf-Auflage 156 entfallen zu lassen, so dass der Einführabschnitt 150 der Befestigungsmittel-Durchtrittsöffnung 108 unmittelbar an der Hauptfläche 154 des Gehäusedeckels 100 mündet, welche dann zugleich als Befestigungsmittelkopf-Auflagefläche 152 dient, wie bei der in Fig. 5 dargestellten zweiten Ausführungsform eines Gehäusedeckels 100.

Eine in Fig. 7 ausschnittsweise dargestellte vierte Ausführungsform eines Gehäusedeckels 100 unterscheidet sich von der vorstehend beschriebenen, in den Fig. 1 bis 4 dargestellten ersten Ausführungsform dadurch, dass der Befestigungsmittel-Durchtrittsöffnungs-Abschnitt 136 des Verformungsbegrenzungselements 132 sich über einen Umfangswinkel α von 360° ringförmig geschlossen um die Befestigungsmittel-Durchtrittsöffnung 108 herum erstreckt.

Ferner ist der Befestigungsmittel-Durchtrittsöffnungs-Abschnitt 136 des Verformungsbegrenzungselements 132 bei dieser Ausführungsform vorzugsweise einteilig ausgebildet, also nicht in mehrere, längs der Umfangsrichtung der Befestigungsmittel-Durchtrittsöffnung 108 voneinander beabstandete Teilelemente 140 unterteilt.

Außerdem weist der Befestigungsmittel-Durchtrittsöffnungs-Abschnitt 136 des Verformungsbegrenzungselements 132 bei dieser Ausführungsform eine Breite B auf, welche längs der Umfangsrichtung der Befestigungsmittel-Durchtrittsöffnung 108 nicht konstant ist, sondern variiert.

Insbesondere variiert die Breite B des Befestigungsmittel-Durchtrittsöffnungs-Abschnitts 136 des Verformungsbegrenzungselements 132 bei dieser Ausführungsform derart, dass die Breite B des Befestigungsmittel-Durchtrittsöffnungs-Abschnitts 136 mit abnehmenden Abstand von dem Dichtungswulst 120 abnimmt.

In dem Bereich des Befestigungsmittel-Durchtrittsöffnungs-Abschnitts 136 des Verformungsbegrenzungselements 132, welcher zwischen der Befestigungsmittel-Durchtrittsöffnung 108 und dem Dichtungswulst 120 und somit auf der dem Dichtungswulst 120 zugewandten Seite der Befestigungsmittel-Durchtrittsöffnung 108 angeordnet ist, nimmt die Breite B ihren minimalen Wert B1 an.

In einem Bereich des Befestigungsmittel-Durchtrittsöffnungs-Abschnitts 136 des Verformungsbegrenzungselements 132, welcher auf der dem Dichtungswulst 120 abgewandten Seite der Befestigungsmittel-Durchtrittsöffnung 108 angeordnet ist, nimmt die Breite B ihren maximalen Wert B2 an (siehe Fig. 7).

Dadurch, dass der Befestigungsmittel-Durchtrittsöffnungs-Abschnitt 136 des Verformungsbegrenzungselements 132 auf der dem Dichtungswulst 120 zugewandten Seite der Befestigungsmittel-Durchtrittsöffnung 108 schmaler ausgebildet ist als auf der dem Dichtungswulst 120 abgewandten Seite der Befestigungsmittel-Durchtrittsöffnung 108, wird erreicht, dass der Dichtungswulst 120 besonders nahe an die Befestigungsmittel-Durchtrittsöffnung 108 heran legbar ist.

Im Übrigen stimmt die in Fig. 7 dargestellte vierte Ausführungsform eines Gehäusedeckels 100 hinsichtlich Aufbau, Funktion und Herstellungsweise mit der in den Fig. 1 bis 4 dargestellten ersten Ausführungsform überein, auf deren vorstehende Beschreibung insoweit Bezug genommen wird.

Eine in Fig. 8 ausschnittsweise dargestellte fünfte Ausführungsform eines Gehäusedeckels 100 unterscheidet sich von der in Fig. 7 dargestellten vierten Ausführungsform dadurch, dass die Befestigungsmittel-Durchtrittsöffnung 108 bei dieser fünften Ausführungsform keine vertiefte Befestigungsmittelkopf-Auflage 156 aufweist, sondern statt dessen der Einführabschnitt 150 der Befestigungsmittel-Durchtrittsöffnung 108 unmittelbar an der Hauptfläche 154 des Gehäusedeckels 100 mündet, welche bei dieser Ausführungsform zugleich als Befestigungsmittelkopf-Auflagefläche 152 dient.

Bei dieser Ausführungsform liegt im montierten Zustand des Gehäusedeckels 100 der Kopf 158 des Befestigungsmittels 112 an der als Befestigungsmittelkopf-Auflagefläche 152 dienenden Hauptfläche 154 des Gehäusedeckels 100 an.

Diese Ausführungsform des Gehäusedeckels 100 ohne eine vertiefte Befestigungsmittelkopf-Auflage 156 wird vorzugsweise dann verwendet, wenn die Dicke oder Materialstärke des Ausgangsmaterials geringer ist als 3,0 mm.

Im Übrigen stimmt die in Fig. 8 dargestellte fünfte Ausführungsform eines Gehäusedeckels 100 hinsichtlich Aufbau, Funktion und Herstellungsweise mit der in Fig. 7 dargestellten vierten Ausführungsform überein, auf deren vorstehende Beschreibung insoweit Bezug genommen wird.

## Patentansprüche

1. Gehäusedeckel zum Festlegen an einem Gehäuse (102), wobei der Gehäusedeckel (100) mit mehreren Befestigungsmittel-Durchtrittsöffnungen (108) und mit einem Dichtungswulst (120), der ein elastomeres Material umfasst, versehen ist und
wobei der Dichtungswulst (120) an einer Dichtungstragefläche (122) des Gehäusedeckels (100) angeordnet ist,
wobei der Gehäusedeckel (100) mindestens ein Verformungsbegrenzungselement (132) umfasst, welches über die Dichtungstragefläche (122) in derselben Richtung vorsteht wie der Dichtungswulst (120) und eine Verformung des Dichtungswulstes (120) im montierten Zustand des Gehäusedeckels (100) begrenzt, und
wobei das Verformungsbegrenzungselement (132) mindestens einen Befestigungsmittel-Durchtrittsöffnungs-Abschnitt (136) umfasst, der sich längs einer Umfangsrichtung einer der Befestigungsmittel-Durchtrittsöffnungen (108) über einen Umfangswinkel (α) um die betreffende Befestigungsmittel-Durchtrittsöffnung (108) erstreckt,
**dadurch gekennzeichnet,**
**dass** mindestens eine der Befestigungsmittel-Durchtrittsöffnungen (108) gestuft ausgebildet ist.

2. Gehäusedeckel nach Anspruch 1, **dadurch gekennzeichnet, dass** die gestuft ausgebildete Befestigungsmittel-Durchtrittsöffnung (108) einen im montierten Zustand des Gehäusedeckels (100) dem Gehäuse (102) zugewandten Zentrierabschnitt (146) und einen im montierten Zustand des Gehäusedeckels (100) dem Gehäuse (102) abgewandten Einführabschnitt (150) umfasst.

3. Gehäusedeckel nach Anspruch 2, **dadurch gekennzeichnet, dass** der Zentrierabschnitt (146) einen Durchmesser (d_{Z}) aufweist, welcher kleiner ist als der Durchmesser (d_{E}) des Einführabschnitts (150).

4. Gehäusedeckel nach einem der Ansprüche 2 oder 3, **dadurch gekennzeichnet, dass** die gestuft ausgebildete Befestigungsmittel-Durchtrittsöffnung (108) einen zwischen dem Zentrierabschnitt (146) und dem Einführabschnitt (150) angeordneten und sich zu dem Zentrierabschnitt (146) hin verjüngenden Verjüngungsabschnitt (148) umfasst.

5. Gehäusedeckel nach einem der Ansprüche 1 bis 4, **dadurch gekennzeichnet, dass** der Befestigungsmittel-Durchtrittsöffnungs-Abschnitt (136) des Verformungsbegrenzungselements (132) sich über einen Umfangswinkel (α) von 360° um die Befestigungsmittel-Durchtrittsöffnung (108) herum erstreckt.

6. Gehäusedeckel nach einem der Ansprüche 1 bis 5, **dadurch gekennzeichnet, dass** der Befestigungsmittel-Durchtrittsöffnungs-Abschnitt (136) des Verformungsbegrenzungselements (132) einteilig ausgebildet ist.

7. Gehäusedeckel nach einem der Ansprüche 1 bis 6, **dadurch gekennzeichnet, dass** der Befestigungsmittel-Durchtrittsöffnungs-Abschnitt (136) des Verformungsbegrenzungselements (132) eine Breite (B) aufweist, welche längs der Umfangsrichtung der Befestigungsmittel-Durchtrittsöffnung (108) variiert.

8. Gehäusedeckel nach Anspruch 7, **dadurch gekennzeichnet, dass** die Breite (B) des Befestigungsmittel-Durchtrittsöffnungs-Abschnitts (136) des Verformungsbegrenzungselements (132) mit abnehmendem Abstand von dem Dichtungswulst (120) abnimmt.

9. Gehäusedeckel nach einem der Ansprüche 1 bis 8, **dadurch gekennzeichnet, dass** der Gehäusedeckel (100) einen Grundkörper (104) umfasst und der Befestigungsmittel-Durchtrittsöffnungs-Abschnitt (136) des Verformungsbegrenzungselements (132) durch Prägeformung des Grundkörpers (104) gebildet ist.

10. Gehäusedeckel nach einem der Ansprüche 1 bis 9, **dadurch gekennzeichnet, dass** mindestens eine der Befestigungsmittel-Durchtrittsöffnungen (108) eine gegenüber einer Hauptfläche (154) des Gehäusedeckels (100) vertiefte Befestigungsmittelkopf-Auflage (156) umfasst.

11. Gehäusedeckel nach einem der Ansprüche 1 bis 10, **dadurch gekennzeichnet, dass** der Befestigungsmittel-Durchtrittsöffnungs-Abschnitt (136) des Verformungsbegrenzungselements (132) mehrere Teilelemente (140) umfasst, die längs der Umfangsrichtung der Befestigungsmittel-Durchtrittsöffnung (108) voneinander beabstandet sind.

12. Gehäusedeckel nach Anspruch 11, **dadurch gekennzeichnet, dass** mindestens eines der Teilelemente (140) eine als ein Kreissektorabschnitt ausgebildete Außenkontur aufweist.

13. Gehäusedeckel nach einem der Ansprüche 11 oder 12, **dadurch gekennzeichnet, dass** mindestens eines der Teilelemente (140) des Befestigungsmittel-Durchtrittsöffnungs-Abschnitts (136) sich über einen Umfangswinkel (β) von weniger als 70° erstreckt.

14. Gehäusedeckel nach einem der Ansprüche 11 bis 13, **dadurch gekennzeichnet, dass** zwischen jeweils zwei Teilelementen (140), die längs der Umfangsrichtung der Befestigungsmittel-Durchtrittsöffnung (108) aufeinander folgen, eine Lücke (144) angeordnet ist und mindestens eine der Lücken (144) sich über einen Umfangswinkel (γ) von mehr als 5° erstreckt.

15. Verfahren zum Herstellen eines Gehäusedeckels (100) zum Festlegen an einem Gehäuse (102),
wobei der Gehäusedeckel (100)
mehrere Befestigungsmittel-Durchtrittsöffnungen (108),
einen Dichtungswulst (120), welcher an einer Dichtungstragefläche (122) des Gehäusedeckels (100) angeordnet ist, und
mindestens ein Verformungsbegrenzungselement (132), welches über die Dichtungstragefläche (122) in derselben Richtung vorsteht wie der Dichtungswulst (120) und eine Verformung des Dichtungswulstes (120) im montierten Zustand des Gehäusedeckels (100) begrenzt,
umfasst und
wobei das Verformungsbegrenzungselement (132) mindestens einen Befestigungsmittel-Durchtrittsöffnungs-Abschnitt (136) umfasst, der sich längs einer Umfangsrichtung einer der Befestigungsmittel-Durchtrittsöffnungen (108) über einen Umfangswinkel (α) um die betreffende Befestigungsmittel-Durchtrittsöffnung (108) erstreckt, und
wobei das Verfahren Folgendes umfasst:
- Einprägen einer gestuften Begrenzungswand mindestens einer Befestigungsmittel-Durchtrittsöffnung (108) in den Grundkörper (104) des Gehäusedeckels (100);
- Heraustrennen der Befestigungsmittel-Durchtrittsöffnung (108) aus dem Grundkörper (104) des Gehäusedeckels (100).

## Claims

1. Housing cover for fixing to a housing (102), wherein the housing cover (100) is provided with a plurality of fastening means through-openings (108) and with a sealing bead (120) that comprises an elastomeric material, and
wherein the sealing bead (120) is arranged on a seal support face (122) of the housing cover (100),
wherein the housing cover (100) comprises at least one deformation limiting element (132), which projects over the seal support face (122) in the same direction as the sealing bead (120) and limits a deformation of the sealing bead (120) in the assembled state of the housing cover (100), and
wherein the deformation limiting element (132) comprises at least one fastening means through-opening portion (136) that extends along a circumferential direction of one of the fastening means through-openings (108) over a circumferential angle (α) around the respective fastening means through-opening (108),
**characterized in that**
at least one of the fastening means through-openings (108) is of stepped configuration.

2. Housing cover in accordance with Claim 1, **characterized in that** the fastening means through-opening (108) of stepped configuration comprises a centering portion (146) that faces toward the housing (102) in the assembled state of the housing cover (100) and an insertion portion (150) that faces away from the housing (102) in the assembled state of the housing cover (100).

3. Housing cover in accordance with Claim 2, **characterized in that** the centering portion (146) has a diameter (dz) that is smaller than the diameter (d_{E}) of the insertion portion (150).

4. Housing cover in accordance with either of Claims 2 or 3, **characterized in that** the fastening means through-opening (108) of stepped configuration comprises a tapering portion (148) that is arranged between the centering portion (146) and the insertion portion (150) and tapers toward the centering portion (146).

5. Housing cover in accordance with any one of Claims 1 to 4, **characterized in that** the fastening means through-opening portion (136) of the deformation limiting element (132) extends over a circumferential angle (α) of 360° around the fastening means through-opening (108).

6. Housing cover in accordance with any one of Claims 1 to 5, **characterized in that** the fastening means through-opening portion (136) of the deformation limiting element (132) is of one-part configuration.

7. Housing cover in accordance with any one of Claims 1 to 6, **characterized in that** the fastening means through-opening portion (136) of the deformation limiting element (132) has a width (B) that varies along the circumferential direction of the fastening means through-opening (108).

8. Housing cover in accordance with Claim 7, **characterized in that** the width (B) of the fastening means through-opening portion (136) of the deformation limiting element (132) decreases with decreasing distance from the sealing bead (120).

9. Housing cover in accordance with any one of Claims 1 to 8, **characterized in that** the housing cover (100) comprises a base body (104) and the fastening means through-opening portion (136) of the deformation limiting element (132) is formed by stamping the base body (104).

10. Housing cover in accordance with any one of Claims 1 to 9, **characterized in that** at least one of the fastening means through-openings (108) comprises a fastening means head support (156) that is recessed in relation to a main face (154) of the housing cover (100).

11. Housing cover in accordance with any one of Claims 1 to 10, **characterized in that** the fastening means through-opening portion (136) of the deformation limiting element (132) comprises a plurality of partial elements (140) that are spaced at a distance from one another along the circumferential direction of the fastening means through-opening (108).

12. Housing cover in accordance with Claim 11, **characterized in that** at least one of the partial elements (140) has an outer contour configured as a circular sector portion.

13. Housing cover in accordance with either of Claims 11 or 12, **characterized in that** at least one of the partial elements (140) of the fastening means through-opening portion (136) extends over a circumferential angle (β) of less than 70°.

14. Housing cover in accordance with any one of Claims 11 to 13, **characterized in that** a gap (144) is arranged between two respective partial elements (140) that succeed one another along the circumferential direction of the fastening means through-opening (108), and at least one of the gaps (144) extends over a circumferential angle (γ) of more than 5°.

15. Method for producing a housing cover (100) for fixing to a housing (102),
wherein the housing cover (100) comprises
a plurality of fastening means through-openings (108),
a sealing bead (120), which is arranged on a seal support face (122) of the housing cover (100), and
at least one deformation limiting element (132), which projects over the seal support face (122) in the same direction as the sealing bead (120) and limits a deformation of the sealing bead (120) in the assembled state of the housing cover (100), and
wherein the deformation limiting element (132) comprises at least one fastening means through-opening portion (136) that extends along a circumferential direction of one of the fastening means through-openings (108) over a circumferential angle (α) around the respective fastening means through-opening (108), and
wherein the method comprises the following:
- stamping a stepped delimiting wall of at least one fastening means through-opening (108) into the base body (104) of the housing cover (100);
- separating out the fastening means through-openings (108) from the base body (104) of the housing cover (100).

## Revendications

1. Couvercle de boîtier destiné à être immobilisé sur un boîtier (102), dans lequel le couvercle (100) de boîtier est pourvu de plusieurs ouvertures de passage (108) de moyen de fixation et d'un bourrelet d'étanchéité (120), qui comprend un matériau élastomère, et
dans lequel le bourrelet d'étanchéité (120) est disposé sur une surface de support d'étanchéité (122) du couvercle (100) de boîtier,
dans lequel le couvercle (100) de boîtier comprend au moins un
élément de limitation de déformation (132), qui dépasse de la surface de support de joint (122) dans la même direction que le bourrelet d'étanchéité (120) et limite une déformation du bourrelet d'étanchéité (120) dans l'état monté du couvercle (100) de boîtier, et dans lequel l'élément de limitation de déformation (132) comprend au moins une section (136) d'ouverture de passage de moyen de fixation, qui s'étend le long d'une direction périphérique d'une des ouvertures de passage (108) de moyen de fixation sur un angle périphérique (α) autour de l'ouverture de passage (108) de moyen de fixation concernée,
**caractérisé en ce**
**qu'**au moins une des ouvertures de passage (108) de moyen de fixation est réalisée de manière étagée.

2. Couvercle de boîtier selon la revendication 1, **caractérisé en ce que** l'ouverture de passage (108) de moyen de fixation réalisée de manière étagée comprend une section de centrage (146) tournée vers le boîtier (102) dans l'état monté du couvercle (100) de boîtier et une section d'introduction (150) opposée au boîtier (102) dans l'état monté du couvercle (100) de boîtier.

3. Couvercle de boîtier selon la revendication 2, **caractérisé en ce que** la section de centrage (146) présente un diamètre (dz) qui est inférieur au diamètre (d_{E}) de la section d'introduction (150).

4. Couvercle de boîtier selon l'une quelconque des revendications 2 ou 3, **caractérisé en ce que** l'ouverture de passage (108) de moyen de fixation réalisée de manière étagée comprend une section de rétrécissement (148) disposée entre la section de centrage (146) et la section d'introduction (150) et se rétrécissant vers la section de centrage (146).

5. Couvercle de boîtier selon l'une quelconque des revendications 1 à 4, **caractérisé en ce que** la section (136) d'ouverture de passage de moyen de fixation de l'élément de limitation de déformation (132) s'étend sur un angle périphérique (α) de 360° autour de l'ouverture de passage (108) de moyen de fixation.

6. Couvercle de boîtier selon l'une quelconque des revendications 1 à 5, **caractérisé en ce que** la section (136) d'ouverture de passage de moyen de fixation de l'élément de limitation de déformation (132) est réalisée en une seule pièce.

7. Couvercle de boîtier selon l'une quelconque des revendications 1 à 6, **caractérisé en ce que** la section (136) d'ouverture de passage de moyen de fixation de l'élément de limitation de déformation (132) présente une largeur (B) qui varie le long de la direction périphérique de l'ouverture de passage (108) de moyen de fixation.

8. Couvercle de boîtier selon la revendication 7, **caractérisé en ce que** la largeur (B) de la section (136) d'ouverture de passage de moyen de fixation de l'élément de limitation de déformation (132) diminue au fur et à mesure que la distance par rapport au bourrelet d'étanchéité (120) diminue.

9. Couvercle de boîtier selon l'une quelconque des revendications 1 à 8, **caractérisé en ce que** le couvercle (100) de boîtier comprend un corps de base (104) et que la section (136) d'ouverture de passage de moyen de fixation de l'élément de limitation de déformation (132) est formée par gaufrage du corps de base (104).

10. Couvercle de boîtier selon l'une quelconque des revendications 1 à 9, **caractérisé en ce qu'**au moins une des ouvertures de passage (108) de moyen de fixation comprend un appui (156) de tête de moyen de fixation en retrait par rapport à une surface principale (154) du couvercle (100) de boîtier.

11. Couvercle de boîtier selon l'une quelconque des revendications 1 à 10, **caractérisé en ce que** la section (136) d'ouverture de passage de moyen de fixation de l'élément de limitation de déformation (132) comprend plusieurs éléments partiels (140), qui sont espacés les uns des autres le long de la direction périphérique de l'ouverture de passage (108) de moyen de fixation.

12. Couvercle de boîtier selon la revendication 11, **caractérisé en ce qu'**au moins un des éléments partiels (140) présente un contour extérieur réalisé comme une section de secteur circulaire.

13. Couvercle de boîtier selon l'une quelconque des revendications 11 ou 12, **caractérisé en ce qu'**au moins un des éléments partiels (140) de la section (136) d'ouverture de passage de moyen de fixation s'étend sur un angle périphérique (β) inférieur à 70°.

14. Couvercle de boîtier selon l'une quelconque des revendications 11 à 13, **caractérisé en ce qu'**un espace (144) est disposé entre respectivement deux éléments partiels (140), qui se suivent l'un l'autre le long de la direction périphérique de l'ouverture de passage (108) de moyen de fixation et au moins un des espaces (144) s'étend sur un angle périphérique (γ) supérieur à 5°.

15. Procédé de fabrication d'un couvercle (100) de boîtier destiné à être immobilisé sur un boîtier (102),
dans lequel le couvercle (100) de boîtier comprend
plusieurs ouvertures de passage (108) de moyens de fixation,
un bourrelet d'étanchéité (120), qui est disposé sur une surface de support d'étanchéité (122) du couvercle (100) de boîtier, et
au moins un élément de limitation de déformation (132), qui dépasse de la surface de support d'étanchéité (122) dans la même direction que le bourrelet d'étanchéité (120) et qui limite une déformation du bourrelet d'étanchéité (120) dans l'état monté du couvercle (100) de boîtier,
et
dans lequel l'élément de limitation de déformation (132) comprend au moins une section (136) d'ouverture de passage de moyen de fixation, qui s'étend le long d'une direction périphérique d'une des ouvertures de passage (108) de moyen de fixation sur un angle périphérique (α) autour de l'ouverture de passage (108) de moyen de fixation concernée, et
dans lequel le procédé comprend ce qui suit :
- l'estampage d'une paroi de délimitation étagée d'au moins une ouverture de passage (108) de moyen de fixation dans le corps de base (104) du couvercle (100) de boîtier ;
- la séparation de l'ouverture de passage (108) de moyen de fixation du corps de base (104) du couvercle (100) de boîtier.
